# EUROPÄISCHE PATENTSCHRIFT

(11) **EP 1 838 897 B1**
(45) Veröffentlichungstag und Bekanntmachung des Hinweises auf die Patenterteilung: **30.04.2014**
(21) Anmeldenummer: 06700446.5
(22) Anmeldetag: 11.01.2006
(51) Int. Cl.: C23C 18/16, C23C 18/54, C23C 18/42, H01L 21/288, H05K 3/24, C23C 18/32, C23C 18/50

(54) **VERFAHREN ZUR ABSCHEIDUNG VON PALLADIUMSCHICHTEN UND PALLADIUMBAD HIERFÜR**
METHOD FOR DEPOSITING PALLADIUM LAYERS AND PALLADIUM BATH THEREFOR
PROCEDE POUR DEPOSER DES COUCHES DE PALLADIUM ET BAIN DE PALLADIUM APPROPRIE

(30) Priorität: 12.01.2005 DE 102005001388
(43) Veröffentlichungstag der Anmeldung: 03.10.2007
(73) Patentinhaber: Umicore Galvanotechnik GmbH, 73525 Schwäbisch Gmünd (DE)
(72) Erfinder: GROSS, Andreas, 75181 Pforzheim (DE); TIEFENBACHER, Andreas, 71540 Murrhardt (DE)
(74) Vertreter: Retzow, Stefan
(86) Internationale Anmeldenummer: PCT/EP2006/000164
(87) Internationale Veröffentlichungsnummer: WO 2006/074902

(56) Entgegenhaltungen:
- EP-A- 1 319 734
- US-A- 5 085 693
- US-A- 5 882 736

## Beschreibung

Die Erfindung betrifft ein Verfahren zur Abscheidung von Palladiumschichten auf Metalloberflächen und ein Bad zur Durchführung des Verfahrens.

In der Elektronikindustrie werden in großen Stückzahlen Schaltungsträger auf organischer (Leiterplatten) und anorganischer Basis (Glas-/ Keramiksubstrate) eingesetzt. Die elektrische Verbindung der bestückten elektronischen Bauelemente untereinander erfolgt üblicherweise durch auf den Schaltungsträgern liegenden Leiterbahnen aus Kupfer. Für eine zuverlässige Verbindungsbildung zwischen den elektronischen Bauelementen und den metallischen Anschlußflächen auf Schaltungsträgerebne ist es notwendig, die Kontaktflächen zusätzlich mit einer oder mehreren metallischen und/oder organischen Deckschichten zu versehen. Dabei werden die physikalisch-chemischen Eigenschaften der Beschichtungsmaterialien genutzt, um die an den gesamten Schichtaufbau gestellten Anforderungen hinsichtlich der Verarbeitbarkeit für die Bauteilmontage und den funktionellen Eigenschaften der kompletten Baugruppe zu erfüllen.

Zur Anfertigung dieser Endschichten sind verschiedene Verfahren bekannt geworden. Die Auswahl eines bestimmten Verfahrens hängt von der geforderten Funktion und seinen Kosten ab. Zur Abscheidung von Metallen aus metallsalzhaltigen Lösungen werden elektrisch negative Ladungen benötigt, die das positiv geladene Metallion durch Reduktion in den nullwertigen Zustand, das heißt in die metallische Form überführen. Bei der galvanischen oder elektrolytischen Metallabscheidung geschieht das unter Zuhilfenahme einer äußeren Stromquelle.

In der Praxis haben sich zur Abscheidung der metallischen Endoberflächen neben den elektrolytischen Prozessen besonders stromlose Beschichtungsprozesse durchgesetzt. Die dabei für die Abscheidung nötigen Ladungen werden entweder durch Ladungsaustauschreaktionen geliefert oder stammen von chemischen Reduktionsmitteln. Stromlose Beschichtungsprozesse benötigen also keine Stromanbindung nach außen. Das Layout der Schaltung läßt sich somit flexibler gestalten. Außerdem sind aufgrund der gleichmäßigeren Schichtverteilung von außenstromlosen Prozessen, dichtere und komplexere Schaltungsentwürfe grundsätzlich besser zu realisieren.

Wegen ihrer Bedeutung für die vorliegende Erfindung sind in Tabelle 1 die beiden stromlosen Beschichtungsprozesse, nämlich Beschichtung durch Ladungsaustausch und Beschichtung durch Autokatalyse (chemische Reduktion) mit ihren gebräuchlichsten Bezeichnungen gegenübergestellt:

**Tabelle 1: Vergleich von außenstromlosen Abscheidungsverfahren am Beispiel von Palladium**

| **Abscheidung durch** | |
|---|---|
| **Autokatalyse** | **Ladungsaustausch** |
| **Abscheidungsreaktion** | |
| **Pd⁺ + R → Pd⁰ + R⁺** | **Pd⁺ + Me° → Pd⁰ + Me⁺** |
| R: organisches oder anorganisches, nichtmetallisches Reduktionsmittel | Me°: weniger edel als Palladium, ist Substrat oder Hilfsanode z.B. Cu, Ni oder Ag |

| **Deutsche Bezeichnung** | |
|---|---|
| - chemisch Palladium | - Ladungsaustauschverfahren |
| - stromlos Palladium | - Sudpalladium |
| - reduktiv Palladium | - Zementationsverfahren |
| - autokatalytisch Palladium | - Verdrängungsverfahren |
| | - (Ionenaustauschverfahren) |

| **Englische Bezeichnung** | |
|---|---|
| - electroless palladium | - immersion palladium |
| - autocatalytic palladium | - strike palladium |
| | - displacement reaction |

Im Rahmen der vorliegenden Erfindung werden für die beiden Verfahren die Begriffe Abscheidung durch Autokatalyse und Abscheidung durch Ladungsaustausch verwendet.

Bei der Abscheidung mit Hilfe von Autokatalyse werden die im Beschichtungsbad enthaltenen positiven Metallionen durch eine zusätzliche, reduzierend wirkende Komponente R reduziert und abgeschieden.

Bei der Verwendung autokatalytischer Beschichtungsbäder besteht immer die Gefahr der Selbstzersetzung der Elektrolyte durch Reduktion der Metallionen schon im Bereitstellungsbetrieb. Es wird versucht, diese Selbstzersetzung durch Zugabe geeigneter Badkomponenten (Komplexbildner + Stabilisatoren) entgegenzuwirken und ein optimales Verhältnis zwischen Badstabilität und Aktivitätsverhalten des Elektrolyten einzustellen.

Im Idealfall werden ausschließlich auf den zu beschichtenden, metallischen Funktionsflächen Metallionen reduktiv abgeschieden. Unerwünschte Selbstzersetzungsreaktionen, das heißt die Metallabscheidung auf Nichtfunktionsflächen wie z.B. Behälterwand, Heizeinrichtungen und Verrohrungen aber auch auf nichtmetallischen Bestandteilen der Schaltungsträger (freiliegende Basismaterialflächen oder organische Abdeckmaterialien wie z.B. Lötstop-Masken) werden unterbunden.

Beim Ladungsaustauschverfahren werden anders als beim autokatalytischen Verfahren keine Reduktionsmittel zur Abscheidung der Metallionen im Elektrolyten benötigt. Die zur Reduktion der Metallionen notwendigen Elektronen stammen von dem Substratmaterial beziehungsweise der Zwischenschicht. Das unedlere Material des Substrats oder der Zwischenschicht (z.B. Cu, Ni, Ag und die entsprechenden Legierungen) löst sich beim Beschichtungsvorgang auf, die dazugehörigen Metallionen gehen in Lösung, das edlere Metall, das als Ion in Lösung vorliegt, nimmt die freiwerdenden Elektronen auf und scheidet sich auf dem Substratmaterial oder der Zwischenschicht in metallischer Form ab. Wesentlich für dieses Verfahren ist die Tatsache, daß früher oder später der Ladungsaustausch zum Erliegen kommt, sobald eine ausreichend dicke und dichte Schicht des edleren Metalls abgeschieden wurde, so daß sich das Substratmaterial nicht weiter auflösen kann. Die üblicherweise erreichbare maximale Schichtdicke liegt bei wenigen nm bis zu ca. 1µm, abhängig von der Art und Oberflächengüte des Substratmaterials und von der Zusammensetzung des Elektrolyten.

Die am weitesten verbreiteten stromlosen Beschichtungsverfahren für die Verwendung als Endoberfläche auf hochwertigen Schaltungsträgern mit geforderter Mehrfachlötbarkeit sind Zinn und Silber durch Ladungsaustausch abgeschieden und der autokatalytisch arbeitende Nickel (-legierung)/Sudgoldprozeß. Für die Auswahl und den Einsatz eines dieser Verfahren im Produktionsmaßstab spielt die Gewichtung der verfahrens- und materialspezifischen Vor- und Nachteile der einzelnen Systeme eine ausschlaggebende Rolle.

Werden an die Endoberflächen der Schaltungsträger, dem Fügepartner der elektronischen Baugruppe auf Substratseite, erweiterte Anforderung hinsichtlich Funktion und Zuverlässigkeit der Verbindungsbildung gestellt, müssen jedoch alternative Schichtsysteme eingesetzt werden. So erfordern immer komplexere und höherintegrierte elektronische Bauelemente oft eine Kombination verschiedener Aufbau- und Montagetechniken auf derselben Schaltungsträgeroberfläche, um die elektrische Entflechtung auf die nachfolgenden Verbindungsebenen optimal gestalten zu können. Neben der Verarbeitbarlceit der Endschicht für unterschiedliche und mehrfach angewendete Lötverfahren (Welle und Reflow) ist neben der Klebbarkeit hierbei besonders auch die Eignung für das Bonden mit Aluminiumdraht und/oder Golddraht gefordert.

Das Drahtbonden ist ein Mikro-Preßschweißverfahren, bei dem gleich- oder verschiedenartige Werkstoffe durch Druck sowie Temperatur und/oder Ultraschall im festen Zustand miteinander verbunden werden.

Gewöhnlich enthält ein hierfür geeignetes Beschichtungssystem einen Schichtaufbau aus Nickel oder Nickellegierungen als Diffusionssperre und Endschichten aus dem Bereich der Edelmetalle, vor allem auf Gold-, Silber- und Palladiumbasis.

Zur Erfüllung des dargestellten Anforderungsprofils für die Kombination von Löten und Bonden auf einer Oberfläche gibt es zur Zeit zwei am Markt erprobte Beschichtungsverfahren, mit denen sowohl prozeßsicher Aluminiumdraht mittels des Ultraschallbondens als auch Golddraht mittels Thermosonicbonden verarbeitet werden kann:
● Autokatalytisch (chemisch) Nickel/Sudgold gefolgt von autokatalytisch abgeschiedenem Gold zur Verstärkung der Goldschicht auf die geforderte Schichthöhe (In der Regel 0,5 µm Gold, um zuverlässige Golddrahtbondverbindungen herstellen zu können).
• Autokatalytisch Nickel gefolgt von autokatalytisch abgeschiedenem Palladium (bis zu 0,5 µm) mit abschließender Abscheidung von Gold mittels Ladungsaustauschprozeß zum Schutz des Palladiums vor chemischer Veränderung aufgrund seiner hohen Reaktionsfähigkeit.

Beide Schichtsysteme besitzen eine multifunktionale Oberfläche mit guter Löt- und Bondbarkeit sowohl für tragfähige Stromzuführungen mit Aluminiumdickdraht als auch für Aluminium- oder Golddünndraht zur Kontaktierung des IC (Chip) auf dem Trägermaterial. Allerdings bedeutet die Verwendung von autokatalytischen Edelmetallprozessen (Gold oder Palladium) für den Schichthersteller eine aufwendige Prozeßführung. Darüber hinaus erfordern die beiden Schichtsysteme relativ dicke Edelmetallschichten, was einen entsprechenden Einfluß auf die Kosten des gesamten Schichtsystems hat.

Autokatalytische Prozesse zur Herstellung multifunktionaler Oberflächen auf Leiterplatten weisen außerdem folgende Nachteile auf:
- hoher fertigungstechnischer Aufwand zur Realisierung einer prozeßsicheren Badführung mit qualitativ hochwertigen Beschichtungsergebnissen.
- Die Zusammensetzung der Elektrolyten ist bedingt durch die ablaufenden Reaktionsmechanismen relativ komplex aufgebaut. Entsprechend hoch sind die sich daraus ergebenden Kosten für das Arbeiten mit diesen autokatalytischen Prozessen aufgrund der Verwendung und dem Verbrauch der eingesetzten Chemikalien.
- Zur Erzielung der erforderlichen multifunktionalen Schichteigenschaften (insbesondere prozeßsicheres Thermosonic-Bonden mit Golddraht) sind hohe Schichtstärken von den Endabnehmern (= Bauteilbestückern) spezifiziert worden. Durch die Verwendung von Edelmetallen als Funktionsschichten ergibt sich hierbei ein nicht unerheblicher Einfluß auf die Gesamtprozeßkosten.

Die EP 0 701 281 A1 beschreibt ein Substrat mit bondfähiger Beschichtung für das Bonden von Gold-Drähten mit Hilfe des Thermosonic-Verfahrens. Die Beschichtung weist eine Kombination aus einer Nickel- oder Nickellegierungsschicht, einer Palladium enthaltenden Schicht und einer Gold- oder Goldlegierungsschicht auf. Die Schichten werden chemisch (stromlos) oder galvanisch abgeschieden. Eine genauere Spezifikation der Abscheideverfahren wird nicht gegeben.

Die EP 1 319 734 A1 beschreibt ein Beschichtungsverfahren zur stromlosen Beschichtung eines Metalls mit einer haftfesten Goldschicht. Eine gute Haftfestigkeit der Goldschicht wird durch Vorbeschichten des Metalls mit einer Palladiumschicht gewährleistet. Die Palladiumschicht wird zum Beispiel durch Ladungsaustausch aus einem Immersionsbad abgeschieden. Solche Immersions- oder Strike-Bäder werden zum Beispiel in den US-Patentschriften US 5,178,745 und US 5,212,138 beschrieben und werden für die Abscheidung von Haftschichten und zur Einleitung einer nachfolgenden stromlosen Abscheidung von Nickel verwendet.

Der vorliegenden Erfindung liegt die Aufgabe zugrunde, ein Verfahren zur Abscheidung von Palladiumschichten auf metallischen Funktionsflächen anzugeben, welche für die Kombination verschiedener Aufbau- und Montagetechniken auf derselben Substratoberfläche geeignet sind und die genannten Nachteile aus dem Stand der Technik vermeiden.

Gelöst wird das Problem durch ein Verfahren zur Aufbringung einer Funktionsbeschichtung auf einem Substratmetall enthaltend eine Nickel- oder Nickellegierungsschicht, eine Palladiumschicht und gegebenenfalls eine Gold- oder Goldlegierungsschicht, wobei die Nickel- oder Nickellegierungsschicht autokatalytisch mit einem organischen oder anorganischen, nichtmetallischen Reduktionsmittel, die Palladiumschicht durch Ladungsaustausch in Abwesenheit eines Reduktionsmittels und die abschließende Gold- oder Goldlegierungsschicht wiederum durch Ladungsaustausch oder autokatalytisch abgeschieden wird, wobei das Bad zur Abscheidung der Palladiumschicht neben einem Palladiumsalz eine anorganische Verbindung wenigstens eines der Elemente Kupfer, Thallium, Selen und Tellur enthält, bevorzugt Kupfer.

Das Substratmetall bildet gewöhnlich die Leiterbahnen eines elektronischen Schaltungsträgers und ist vorrangig ausgewählt aus Kupfer oder einer Kupferlegierung. Jedes andere leitfähige Material, wie z.B. Silber oder eine Silberlegierung ist jedoch grundsätzlich auch als Substratmaterial möglich.

Für Lötanwendungen bei höchsten Anforderungen an die thermische Belastbarkeit der Oberfläche und einer Eignung zum Aluminiumdraht-Bonden sind auch erfindungsgemäße Schichtaufbauten bestehend nur aus einer autokatalytisch aufgebrachten Nickel- oder Nickellegierungsschicht und der Palladiumschicht aus dem Ladungsaustauschverfahren als Endschicht ohne abschließende Vergoldung erfolgreich getestet worden. Vorteilhaft ist hierbei der Schutz des Nickels vor Oxidation durch die gute Diffusionssperrwirkung des Palladiums.

Das vorgeschlagene Verfahren verzichtet auf einen autokatalytischen Prozeßschritt bei der Edelmetallabscheidung. Stattdessen wird die Palladiumabscheidung auf der Nickel- oder Nickellegierungs-Zwischenschicht durch einen reinen Ladungsaustauschprozeß mit Hilfe eines neuformulierten Palladiumbades realisiert.

Die Abscheidung durch Ladungsaustausch von Palladium aus einer wässrigen Lösung ist bekannt. In der Regel sind die Lösungen aus einer anorganischen oder organischen Säure und dem entsprechenden Palladiumsalz zusammengesetzt. Sie werden im Elektronikbereich vorzugsweise zur Aktivierung von Kupfer- und Silberschichten eingesetzt, um eine nachfolgend durchgeführte autokatalytische Vernickelung einzuleiten.

Diese bekannten Palladiumbäder sind jedoch nicht geeignet, auf einer schon vorhanden Nickellegierungsschicht (autokatalytisch aufgebracht) eine Palladiumschicht mit der geforderten Multifunktionalität abzuscheiden. Beim Ladungsaustausch von Palladium auf Nickel oder dessen Legierungen aus den bekannten Bädern werden vielmehr inhomogene, nichthaftende, porenreiche Schichten abgeschieden, die qualitativ nicht den erforderlichen Ansprüchen hinsichtlich Lötbarkeit, Bondbarkeit oder auch der Verbesserung des Korrosionsverhaltens genügen.

Es wurde überraschenderweise gefunden, daß die gestellten Anforderungen bezüglich Mehrfachlötbarkeit und Bondbarkeit nur erfüllt werden können, wenn dem Palladiumbad neben einem Palladiumsalz eine anorganische Verbindung wenigstens eines der Elemente Kupfer, Thallium, Selen und Tellur zugefügt wird. Bevorzugt wird eine Kupferverbindung, insbesondere Kupfersulfat, verwendet. Mit diesem Zusatz werden auf der Zwischenschicht, in der Regel autokatalytisch Nickel, festhaftende, optisch homogene, porenarme, dünne Palladiumschichten erhalten. Der Zusatz selbst kann in dem fertigen Schichtsystem mit den üblichen Standard-Analyseverfahren (z.B. REM-EDX) jedoch nicht nachgewiesen werden.

Bevorzugt enthält das Palladiumbad zur Abscheidung der Palladiumschicht durch Ladungsaustausch mindestens ein Palladiumsalz mit anorganischem oder organischem Anion ausgewählt aus der Gruppe bestehend aus Palladiumsulfat, Palladiumnitrat, Palladiumchlorid und Palladiumacetat, sowie eine Säurematrix aus mindestens einer Mineralsäure ausgewählt aus der Gruppe bestehend aus Schwefelsäure, Salpetersäure, Phosphorsäure und Salzsäure. Bevorzugt werden chlorfreie Komponenten verwendet.

Durch das Molverhältnis zwischen Palladium und den Mineralsäuren des Elektrolyten kann seine Aktivität und sein Abscheideverhalten in einer für die zuverlässige Funktionalität der Oberfläche erforderlichen Qualität eingestellt werden. Gute Ergebnisse werden mit einem Molverhältnis zwischen Palladium und den Mineralsäuren von 1 : 500 bis 1 : 2000 erhalten.

Die Abscheidung der Palladiumschicht kann bei einer Temperatur des Beschichtungsbades zwischen Raumtemperatur und 70, bevorzugt zwischen 25 und 50 °C vorgenommen werden. Der pH-Wert des Bades hängt von dem gewählten Molverhältnis zwischen Palladium und den Mineralsäuren ab. Bei den oben angegebenen Molverhältnissen liegt der pH-Wert stets im sauren Bereich zwischen 0 und 4 und ist damit gut verträglich mit den Materialien der Schaltungsträger. Bevorzugt liegt der pH-Wert zwischen 0 und 2.

Die Dicke der sich bildenden Palladiumschicht hängt von der Einwirkungszeit des Palladiumbades ab. Porenarme Palladiumschichten mit guter Homogenität lassen sich mit Einwirkungszeiten zwischen 1 und 20 Minuten abscheiden. Die Schichtdicke beträgt dabei zwischen einigen Nanometern und 100 nm, bevorzugt zwischen 10 und 80 nm, insbesondere zwischen 10 und 40 nm.

In einer Ausführungsform des Palladiumbades zur Abscheidung einer Palladiumschicht durch Ladungsaustausch auf einer Nickel oder Nickel-Phosphorlegierungsschicht, weist das Bad bevorzugt die folgende Zusammensetzung auf:
a) 10 bis 1000, insbesondere 10 bis 500 mg/l Palladium aus mindestens einem Palladiumsalz mit anorganischem oder organischem Anion ausgewählt aus der Gruppe bestehend aus Palladiumsulfat, Palladiumnitrat und Palladiumacetat,
b) 5 bis 500, insbesondere 10 bis 200 g/l mindestens einer Mineralsäure ausgewählt aus der Gruppe bestehend aus Schwefelsäure, Salpetersäure und Phosphorsäure, und
c) 1 bis 200, insbesondere 2 bis 50 mg/l, wenigstens eines der Elemente Kupfer, Thallium, Selen und Tellur aus anorganischen Verbindungen dieser Elemente.

Zur Verbesserung seiner Stabilität können dem Palladiumbad bestimmte Komponenten zugegeben werden, die eine komplexierende Wirkung auf Nickel und/oder Palladium ausüben. Beispiele solcher Badzusätze sind verschiedene Hydroxycarbonsäuren mit und ohne funktioneller Mercaptogruppe wie Zitronensäure, Weinsäure oder Thioglykolsäure, bestimmte Aminverbindungen wie Triethanolamin, Tren oder auch Penten sowie die bekannten EDTA-Derivate (zum Beispiel die bekannten Titriplex-Verbindungen) zur Komplexierung von Metallionen. Bevorzugt wird das Komplexierungsmittel dem Palladiumbad in einer Konzentration von 1 bis 200, insbesondere 2 bis 50 g/l zugefügt.

Durch zahlreich durchgeführte Untersuchungen des Löt- und Bondverhaltens auch nach thermischer Alterung der Schaltungsträger vor dem eigentlichen Bestückungsvorgang konnte eindrucksvoll belegt werden, daß das nach dem erfindungsgemäßen Verfahren auf Kupferleiterbahnen hergestellte Schichtsystem aus einer Nickel- oder Nickellegierungs-Zwischenschicht mit darauf durch Ladungsaustausch abgeschiedenem Palladium und gegebenenfalls einer abschließenden dünnen Goldbeschichtung von kleiner 0,1 µm hervorragend gegenüber Oxidation und einer gegenseitigen Diffusion der Einzelschichten beständig ist. Das macht das erfindungsgemäß abgeschiedene Schichtsystem besonders gut für Thermosonic-Bondverfahren mit Golddraht geeignet.

Die optionale Goldschicht mit einem Feingehalt von größer 99 % kann aus einem konventionellen Ladungsaustauschbad abgeschieden und zusätzlich durch bekannte autokatalytische Prozesse auf eine gewünschte Dicke nachverstärkt werden. Zusätzliche Untersuchungen der Erfinder zur Auswirkung von Schadgaseinflüssen auf das Korrosionsverhalten der erfindungsgemäß abgeschiedenen Schichtsysteme zeigen eine deutliche Verbesserung der Ergebnisse bei Verwendung des Ladungsaustauschprozesses für Palladium auf autokatalytisch Nickel gegenüber reinen autokatalytisch Nickel/Gold-Schichten aus dem Stand der Technik.

Die gemäß der Erfindung auf Nickel durch Ladungsaustausch aufgebrachte dünne Palladiumschicht ist porenarm und bildet eine gute Diffusionssperre gegenüber der Diffusion von Nickel in die optionale Goldschicht. Ohne den Zusatz von anorganischen Verbindungen wenigstens eines der Elemente Kupfer, Thallium, Selen und Tellur zum Ladungsaustauschbad wird dagegen keine ausreichende Haftung und Sperrwirkung der Palladiumschicht erreicht.

### Beispiel 1:

Auf die Kupferleiterbahnen eines Schaltungsträgers wurde nach dem erfindungsgemäßen Verfahren ein Schichtsystem Nickel/Palladium/Gold abgeschieden.

Die Nickelschicht mit einer Dicke von etwa 5µm wurde mit Hilfe eines handelsüblichen Bades autokatalytisch abgeschieden. Zur nachfolgenden Abscheidung von Palladium durch Ladungsaustausch wurde ein Bad mit 100 mg/l Palladium als Palladiumsulfat, 50 g/l Schwefelsäure, 10 mg/l Kupfer als Kupfersulfat und 10 g/l Zitronensäure eingesetzt. Das Molverhältnis von Palladium zur Schwefelsäure betrug somit etwa 1 : 540. Der pH-Wert dieses Bades war kleiner 1. Es ergaben sich nach 5, 10 und 15 Minuten Einwirkungszeit des Palladiumbades bei Raumtemperatur festhaftende, homogene und porenarme Schichten auf der Nickel-Zwischenschicht. Auf diesen Schichten wurde abschließend eine Gold-Deckschicht mit einer Dicke von < 0,1 µm durch Ladungsaustausch aufgebracht.

Das fertige Schichtsystem war auch bei erhöhter thermischer Belastung (z.B. 4h bei 155 °C) hervorragend mehrfachlötbar und bondbar, sowohl mit Aluminium- als auch mit Golddraht.

### Beispiel 2:

Beispiel 1 wurde mit einem Palladiumbad mit 100 mg/l Palladium als Palladiumsulfat, 100 g/l Phosphorsäure und 50 mg/l Kupfer als Kupfersulfat wiederholt. Das Molverhältnis von Palladium zur Phosphorsäure betrug somit etwa 1 : 1100. Das Bad besaß einen pH-Wert von < 1. Auch dieses Palladiumbad ergab dieselben positiven Schichteigenschaften wie in Beispiel 1.

## Patentansprüche

1. Verfahren zur Aufbringung einer Funktionsbeschichtung auf einem Substratmetall, wobei die Funktionsbeschichtung beginnend von der Metalloberfläche eine Nickel- oder eine Nickellegierungschicht, eine Palladiumschicht und gegebenenfalls eine Gold- oder Goldlegierungsschicht enthält, die jeweils unter Verwendung entsprechender Beschichtungsbäder abgeschieden werden,
**dadurch gekennzeichnet,**
**daß** die Nickel- oder Nickellegierungsschicht autokatalytisch mit einem organischen oder anorganischen, nichtmetallischen Reduktionsmittel, die Palladiumschicht durch Ladungsaustausch in Abwesenheit eines Reduktionsmittels und die Gold- oder Goldlegierungsschicht ebenfalls durch Ladungsaustausch oder autokatalytisch abgeschieden wird, wobei das Bad zur Abscheidung der Palladiumschicht neben einem Palladiumsalz eine anorganische Verbindung wenigstens eines der Elemente Kupfer, Thallium, Selen und Tellur enthält.

2. Verfahren nach Anspruch 1,
**dadurch gekennzeichnet,**
**daß** das Beschichtungsbad zur Abscheidung der Palladiumschicht durch Ladungsaustausch mindestens ein Palladiumsalz mit anorganischem oder organischem Anion ausgewählt aus der Gruppe bestehend aus Palladiumsulfat, Palladiumnitrat, Palladiumchlorid und Palladiumacetat enthält sowie eine Säurematrix aus mindestens einer Mineralsäure ausgewählt aus der Gruppe bestehend aus Schwefelsäure, Salpetersäure, Phosphorsäure und Salzsäure.

3. Verfahren nach Anspruch 2,
**dadurch gekennzeichnet,**
**daß** das Molverhältnis zwischen Palladium und der oder den Mineralsäuren in einem Bereich von 1 : 500 bis 1 : 2000 liegt.

4. Verfahren nach Anspruch 3,
**dadurch gekennzeichnet,**
**daß** die Abscheidung der Palladiumschicht bei einer Temperatur des Beschichtungsbades zwischen Raumtemperatur und 70 °C und bei einem pH-Wert zwischen 0 und 4 vorgenommen wird.

5. Verfahren nach Anspruch 4,
**dadurch gekennzeichnet,**
**daß** die Abscheidung der Palladiumschicht bei einer Temperatur des Beschichtungsbades zwischen 25 und 50 °C vorgenommen wird.

6. Verfahren nach einem der vorstehenden Ansprüche,
**dadurch gekennzeichnet,**
**daß** die Einwirkungsdauer des Beschichtungsbades für Palladium zwischen 1 und 20 Minuten gewählt wird.

7. Verfahren nach Anspruch 1,
**dadurch gekennzeichnet,**
**daß** das Substratmetall die Leiterbahnen eines elektronischen Schaltungsträgers bildet und ausgewählt ist aus Kupfer oder einer Kupferlegierung oder anderen leitfähigen Materialien.

8. Verfahren nach Anspruch 1,
**dadurch gekennzeichnet,**
**daß** die Nickellegierung eine Nickel/Bor-, Nickel/Phosphor-, Nickel/Eisen/Phosphor-, Nickel/Phosphor/Wolfram-, Nickel/Kobalt/Phosphor- oder eine Nickel/Wolfram-Legierung ist.

9. Verfahren nach Anspruch 1,
**dadurch gekennzeichnet,**
**daß** die Goldschicht mit einem Feingehalt von größer 99 % aus einem konventionellen Ladungsaustauschbad abgeschieden und zusätzlich durch bekannte autokatalytische Prozesse auf eine gewünschte Dicke nachverstärkt wird.

10. Palladiumbad zur Abscheidung einer Palladiumschicht durch Ladungsaustausch auf einer Nickelschicht nach dem Verfahren gemäß einem der vorstehenden Ansprüche,
**dadurch gekennzeichnet,**
**daß** das Bad folgende Komponenten enthält:
a) 10 bis 1000 mg/l Palladium aus mindestens einem Palladiumsalz mit anorganischem oder organischem Anion ausgewählt aus der Gruppe bestehend aus Palladiumsulfat, Palladiumnitrat und Palladiumacetat,
b) 5 bis 500 g/l mindestens einer Mineralsäure ausgewählt aus der Gruppe bestehend aus Schwefelsäure, Salpetersäure und Phosphorsäure, und
c) 1 bis 200 mg/l wenigstens eines der Elemente Kupfer, Thallium, Selen und Tellur aus anorganischen Verbindungen dieser Elemente.

11. Palladiumbad nach Anspruch 10,
**dadurch gekennzeichnet,**
**daß** es zur Verbesserung der Abscheideleistung des Elektrolyten und der Badstabilität 1 bis 200 g/l eines Komplexierungsmittels für Nickel und/oder Palladium ausgewählt aus der Gruppe bestehend aus Hydroxycarbonsäuren mit und ohne funktioneller Mercaptogruppe und Aminverbindungen enthält.

## Claims

1. Process for applying a functional layer to a substrate metal, with the functional layer comprising, starting from the metal surface, a nickel or nickel alloy layer, a palladium layer and, if desired, a gold or gold alloy layer which are each deposited using appropriate coating baths, **characterized in that** the nickel or nickel alloy layer is deposited autocatalytically with an organic or inorganic, nonmetallic reducing agent, the palladium layer is deposited by charge exchange in the absence of a reducing agent and the gold or gold alloy layer is likewise deposited by charge exchange or autocatalytically, with the bath for deposition of the palladium layer comprising not only a palladium salt but also an inorganic compound of at least one of the elements copper, thallium, selenium and tellurium.

2. Process according to Claim 1, **characterized in that** the coating bath for the deposition of the palladium layer by charge exchange comprises at least one palladium salt having an inorganic or organic anion selected from the group consisting of palladium sulfate, palladium nitrate, palladium chloride and palladium acetate and also an acid matrix comprising at least one mineral acid selected from the group consisting of sulfuric acid, nitric acid, phosphoric acid and hydrochloric acid.

3. Process according to Claim 2, **characterized in that** the molar ratio of palladium to the mineral acid or acids is in the range from 1:500 to 1:2000.

4. Process according to Claim 3, **characterized in that** the deposition of the palladium layer is carried out at a temperature of the coating bath in the range from room temperature to 70°C and at a pH in the range from 0 to 4.

5. Process according to Claim 4, **characterized in that** the deposition of the palladium layer is carried out at a temperature of the coating bath of from 25 to 50°C.

6. Process according to any of the preceding claims, **characterized in that** the contact time of the coating bath for palladium is in the range from 1 to 20 minutes.

7. Process according to Claim 1, **characterized in that** the substrate metal forms the conductor tracks of an electronic circuit board and is selected from among copper, a copper alloy and other conductive materials.

8. Process according to Claim 1, **characterized in that** the nickel alloy is a nickel/boron, nickel/phosphorus, nickel/iron/phosphorus, nickel/phosphorus/tungsten, nickel/cobalt/phosphorus or a nickel/tungsten alloy.

9. Process according to Claim 1, **characterized in that** the gold layer having a purity of greater than 99% is deposited from a conventional charge exchange bath and is additionally thickened further to a desired thickness by means of known autocatalytic processes.

10. Palladium bath for the deposition of a palladium layer on a nickel layer by charge exchange by means of the process according to any of the preceding claims, **characterized in that** the bath contains the following components:
a) from 10 to 1000 mg/l of palladium from at least one palladium salt having an inorganic or organic anion selected from the group consisting of palladium sulfate, palladium nitrate and palladium acetate,
b) from 5 to 500 g/l of at least one mineral acid selected from the group consisting of sulfuric acid, nitric acid and phosphoric acid and
c) from 1 to 200 mg/l of at least one of the elements copper, thallium, selenium and tellurium from inorganic compounds of these elements.

11. Palladium bath according to Claim 10, **characterized in that** it contains from 1 to 200 g/l of a complexing agent for nickel and/or palladium selected from the group consisting of hydroxycarboxylic acids with and without a functional mercapto group and amine compounds to improve the deposition performance of the electrolyte and the bath stability.

## Revendications

1. Procédé pour déposer un revêtement fonctionnel sur un substrat métallique, dans lequel le revêtement fonctionnel contient, en partant de la surface du métal, une couche de nickel ou d'alliage de nickel, une couche de palladium et éventuellement une couche d'or ou d'alliage d'or, qui sont déposées respectivement en utilisant des bains de revêtement correspondants, **caractérisé en ce que** l'on dépose la couche de nickel ou d'alliage de nickel par voie autocatalytique avec un agent réducteur organique ou inorganique non métallique, la couche de palladium par échange de charge en l'absence d'un agent réducteur, et la couche d'or ou d'alliage d'or également par échange de charge ou par voie autocatalytique, dans lequel le bain destiné au dépôt de la couche de palladium contient, en plus d'un sel de palladium, un composé inorganique d'au moins un des éléments cuivre, thallium, sélénium et tellure.

2. Procédé selon la revendication 1, **caractérisé en ce que** le bain de revêtement destiné au dépôt de la couche de palladium par échange de charge contient au moins un sel de palladium avec un anion inorganique ou organique choisi dans le groupe composé du sulfate de palladium, du nitrate de palladium, du chlorure de palladium et de l'acétate de palladium, ainsi qu'une matrice acide en au moins un acide minéral choisi dans le groupe composé de l'acide sulfurique, de l'acide nitrique, de l'acide phosphorique et de l'acide chlorhydrique.

3. Procédé selon la revendication 2, **caractérisé en ce que** le rapport molaire entre le palladium et le ou les acide(s) minéral/minéraux se situe dans une plage de 1:500 à 1:2000.

4. Procédé selon la revendication 3, **caractérisé en ce que** l'on opère le dépôt de la couche de palladium à une température du bain de revêtement comprise entre la température ambiante et 70°C et avec un pH compris entre 0 et 4.

5. Procédé selon la revendication 4, **caractérisé en ce que** l'on opère le dépôt de la couche de palladium à une température du bain de revêtement comprise entre 25 et 50°C.

6. Procédé selon l'une quelconque des revendications précédentes, **caractérisé en ce que** l'on choisit la durée d'action du bain de revêtement pour le palladium entre 1 et 20 minutes.

7. Procédé selon la revendication 1, **caractérisé en ce que** le substrat métallique forme les pistes conductrices d'un support de circuit électronique et est choisi parmi le cuivre ou un alliage de cuivre ou d'autres matériaux conducteurs.

8. Procédé selon la revendication 1, **caractérisé en ce que** l'alliage de nickel est un alliage nickel/bore, nickel/phosphore, nickel/fer/phosphore, nickel/-phosphore/tungstène, nickel/cobalt/phosphore ou un alliage nickel/tungstène.

9. Procédé selon la revendication 1, **caractérisé en ce que** l'on dépose la couche d'or avec un titre légal de plus de 99 % à partir d'un bain d'échange de charge conventionnel et on la renforce en plus ensuite à une épaisseur souhaitée par des processus autocatalytiques connus.

10. Bain de palladium destiné au dépôt d'une couche de palladium par échange de charge sur une couche de nickel par le procédé selon l'une quelconque des revendications précédentes, **caractérisé en ce que** le bain contient les composants suivants:
a) 10 à 1000 mg/l de palladium en au moins un sel de palladium avec un anion inorganique ou organique choisi dans le groupe composé du sulfate de palladium, du nitrate de palladium et de l'acétate de palladium,
b) 5 à 500 g/l d'au moins un acide minéral choisi dans le groupe composé de l'acide sulfurique, de l'acide nitrique et de l'acide phosphorique, et
c) 1 à 200 mg/l d'au moins un des éléments cuivre, thallium, sélénium et tellure à partir de composés inorganiques de ces éléments.

11. Bain de palladium selon la revendication 10, **caractérisé en ce que**, pour améliorer la capacité de dépôt de l'électrolyte et la stabilité du bain, il contient 1 à 200 g/l d'un agent complexant pour le nickel et/ou le palladium choisi dans le groupe composé d'acides hydroxycarboxyliques avec et sans groupe mercapto fonctionnel et des composés aminés.
